(19) Europäisches Patentamt
European Patent Office
Office européen des brevets

(11) **EP 4 009 105 B1**

(12) **EUROPEAN PATENT SPECIFICATION**

(45) Date of publication and mention
of the grant of the patent:
**03.06.2026 Bulletin 2026/23**

(21) Application number: **20847436.1**

(22) Date of filing: **30.07.2020**

(51) International Patent Classification (IPC):
**G03F 7/00** *(2006.01)*       **G03F 7/032** *(2006.01)*
**G03F 7/30** *(2006.01)*

(52) Cooperative Patent Classification (CPC):
**G03F 7/3092; B01D 21/26; B04B 3/00**

(86) International application number:
**PCT/JP2020/029212**

(87) International publication number:
**WO 2021/020503 (04.02.2021 Gazette 2021/05)**

(54) **DEVICE FOR RECYCLING DEVELOPER, METHOD FOR RECYCLING DEVELOPER, AND APPARATUS FOR DEVELOPING**

VORRICHTUNG ZUM RECYCLING VON ENTWICKLERN, VERFAHREN ZUM RECYCLING VON ENWICKLERN UND APPARAT FÜR DIE ENTWICKLUNG

DISPOSITIF DE RECYCLAGE DE DÉVELOPPEUR, MÉTHODE DE RECYCLAGE DE DÉVELOPPEUR ET APPAREIL DE DÉVELOPPEMENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.08.2019 JP 2019142373**

(43) Date of publication of application:
**08.06.2022 Bulletin 2022/23**

(73) Proprietor: **TOYOBO MC Corporation
Osaka-shi, Osaka 530-0001 (JP)**

(72) Inventor: **YAMADA, Hiroto
Okayama-shi, Okayama 704-8194 (JP)**

(74) Representative: **Müller-Boré & Partner
Patentanwälte PartG mbB
Friedenheimer Brücke 21
80639 München (DE)**

(56) References cited:
WO-A1-2018/180252     JP-A- H06 504 230
JP-A- H1 147 638      JP-A- H1 147 638
US-A- 4 752 283       US-A- 5 505 863

## Description

Technical Field

The present invention relates to a device for recycling a developer for a flexographic original printing plate, which is capable of efficiently separating and removing a resin flocculate; a method for recycling a developer using such a device; and an apparatus for developing a flexographic original printing plate.

Background Art

A flexographic original printing plate generally has a structure in which a photosensitive resin layer formed of a photosensitive resin composition is provided on a support. Such a flexographic original printing plate is made by, for example, selectively exposing a photosensitive resin layer to ultraviolet light and developing the photosensitive resin layer after the exposure with a water-based developer. The photosensitive resin composition in an unexposed area of the photosensitive resin layer is removed from the printing plate by the development, and dispersed or dissolved in the developer. When the development of the photosensitive resin layer is repeatedly performed using the same developer, the concentration of the photosensitive resin composition dispersed in the developer increases, whereby a developing speed reduces or the dispersed photosensitive resin composition flocculates and forms a suspended resin flocculate. Such a resin flocculate reattaches to the surface of a printing plate, which reduces the quality of the plate surface. Therefore, the developer which contains increased concentration of the photosensitive resin composition needs to be disposed of and replaced with a new developer before restart of the plate making. However, such a repeated disposal of a used developer and replacement with a new developer is not preferred in terms of environmental loads and production costs.

Patent Document 1 discloses a method in which a resin flocculate is actively generated by adding a flocculant to a developer so as to remove the resin flocculate from the developer. However, such an addition of a flocculant involves costs. Further, there is a problem that the developer to which a flocculant has been added cannot directly be recycled as a developer.

As a method for treating a developer so as to recycle and reuse the developer, a filtration separation method has been proposed which uses a filtering medium such as a membrane filter. Patent Document 2 discloses a method for filtering out a resin flocculate by circulating a developer between a concentration tank and a filter. However, such a filtration separation method has a problem that the filter is clogged with the resin flocculate. For example, when a membrane filter is used, backwashing (treatment performed by flowing a filtrate in a direction opposite to a filtration direction) needs to regularly be performed so as to clean the clogged filter.

On the other hand, a centrifugal separation method has been studied as a separation method using no filtering medium. Patent Documents 3 and 4 disclose a method for separating and removing a resin flocculate using a centrifugal settling-type centrifugal separator having an inside disk. Unlike a separation method using a filtering medium, such a method does not have a problem of clogging, and therefore a developer can continuously be treated until the volume of a resin flocculate accumulated in the centrifugal separator reaches its allowable limit. However, in the centrifugal settling-type centrifugal separator used in Patent Documents 3 and 4, it is necessary to arrange an inside disk therein for holding a dispersed solid matter having a specific gravity lower than that of a developer, so as to prevent the dispersed solid matter from flowing out from the inside to the outside of a rotating part of the centrifugal separator. The inside disk used in Patent Document 3 is fixed with screws or the like, and therefore attaching or detaching thereof is troublesome. Patent Document 4 discloses an inside disk that does not need to be fixed. However, setting of optimum conditions is troublesome because of the relationship among a material of the inside disk used, conditions of centrifugal separation, and a developer. Further, it is difficult for the centrifugal separation method using an inside disk disclosed in Patent Documents 3 and 4 to achieve a high resin flocculate separation/removal ratio. In order to solve such problems, there have been demands for a device and a method for recycling a developer, which are capable of recycling the developer without the occurrence of clogging or difficulty in setting treatment conditions and of achieving a high resin flocculate separation/removal ratio. Patent Document 5 describes the processing of waste washout liquid containing photopolymer from printing plate manufacture. Patent Document 6 describes a treatment method and a treatment device.

Prior Art Documents

Patent Documents

Patent Document 1: Japanese Patent Application Laid-Open (JP-A) No. 194824/94
Patent Document 2: Japanese Patent Application Laid-Open (JP-A) No. 34147/98

Patent Document 3: Japanese Patent Application Laid-Open (JP-A) No. 328620/95
Patent Document 4: Japanese Patent Application Laid-Open (JP-A) No. 47638/99
Patent Document 5: US 5 505 863 A
Patent Document 6: WO 2018/180252 A1

Disclosure of the Invention

Problem that the Invention is to Solve

Under the circumstances of the conventional art, it is an object of the present invention to provide a device for recycling a developer for a flexographic original printing plate, which is capable of recycling the developer without the occurrence of clogging or difficulty in setting treatment conditions and of achieving a high resin flocculate separation/-removal ratio; a method for recycling a developer using such a device; and an apparatus for developing a flexographic original printing plate.

Means for Solving the Problem

In order to achieve such an object, the present inventors have intensively studied, and as a result have found that the above object can be achieved by providing a slit in the side surface of a rotating body of a centrifugal separator instead of using the inside disk as disclosed in Patent Document 3 or 4, and by efficiently taking out a developer containing no resin flocculate using such a slit. This finding has led to the completion of the present invention. Thus, the present invention has the following configurations:

A device for recycling a used water-based developer after development of a flexographic original printing plate having a photosensitive resin layer containing a water-dispersible synthetic rubber-based polymer, characterized in that the device comprises a centrifugal separator having a rotating body for separating a resin flocculate from the used water-based developer, wherein a cross-sectional shape of the rotating body in a vertical direction including a rotation shaft of the rotating body substantially has a cylindrical or truncated-conical outline, and wherein the rotating body has a slit provided in a side surface thereof so as to allow the used water-based developer after the centrifugation to flow out from an inside to an outside of the rotating body, wherein, when a total area of an opening of the slit open to the inside of the rotating body is defined as A $cm^2$, and an internal volume of the rotating body is defined as B $cm^3$, a value of a slit opening area ratio (B/A) is in a range of 30000 to 140000.

The device for recycling as defined above, wherein the rotating body is constituted from an upper part and a lower part which are separated from each other, and wherein the slit is formed between the upper part and the lower part.

The device for recycling as defined above, wherein the opening of the slit is provided at a position equal to or higher than a middle of a height of an inner wall of the rotating body.

The device for recycling as defined above, wherein a non-woven fabric or a bag made of a resin sheet for collecting the resin flocculate is provided in such a manner that the non-woven fabric or the bag covers the inner wall of the rotating body.

The device for recycling as defined above, wherein the water-dispersible synthetic rubber-based polymer has a butadiene skeleton and/or a styrene skeleton.

A method for recycling a used water-based developer after development of a flexographic original printing plate having a photosensitive resin layer containing a water-dispersible synthetic rubber-based polymer, characterized in that the method comprises separating a resin flocculate from the used water-based developer by using the recycling device as defined above.

An apparatus for developing a flexographic original printing plate having a photosensitive resin layer containing a water-dispersible synthetic rubber-based polymer, by using a water-based developer containing a recycled water-based developer, characterized in that the apparatus comprises the recycling device as defined above so as to recycle a used water-based developer after development.

Advantages of the Invention

According to the present invention, it is possible to efficiently separate and remove the resin flocculate from the used developer by a simple structure without using any inside disk.

Brief Description of the Drawings

FIG. 1 is a sectional view of an embodiment of a recycling device according to the present invention.

FIG. 2 is a top view of a rotating body of a centrifugal separator of the recycling device shown in FIG. 1.

FIG. 3 is a perspective view of the rotating body of the centrifugal separator of the recycling device shown in FIG. 1, seen from above.

FIG. 4 is a view showing the centrifugal separator of the recycling device shown in FIG. 1, which is under operation.

FIG. 5 is a view showing a state where a treated developer overflows from the centrifugal separator of the recycling device shown in FIG. 1.

FIG. 6 is a view showing a connection path used in Examples.

FIG. 7 is a view showing the cross-sectional shape of a rotating body of a centrifugal separator used in Examples 1 to 4 and 6 to 8 and Comparative Examples 1 and 2, and the position and shape of a slit arranged therein.

FIG. 8 is a view showing the cross-sectional shape of a rotating body of a centrifugal separator used in Example 5, and the position and shape of a slit arranged therein.

FIG. 9 is a view showing the cross-sectional shape of a rotating body of a centrifugal separator used in Example 9, and the position and shape of a slit arranged therein.

FIG. 10 is a view showing the cross-sectional shape of a rotating body of a centrifugal separator used in Example 10, and the position and shape of a slit arranged therein.

FIG. 11 is a view showing the cross-sectional shape of a rotating body of a centrifugal separator used in Example 11, and the position and shape of a slit arranged therein.

FIG. 12(a) is a view showing the cross-sectional shape of a rotating body of a centrifugal separator used in Example 12, and the position and shape of a slit arranged therein, and FIG. 12(b) is a view showing a number of the slit.

FIG. 13(a) is a view showing the cross-sectional shape of a rotating body of a centrifugal separator used in Example 13, and the position and shape of a slit arranged therein, and FIG. 13(b) is a view showing a number of the slit.

FIG. 14 is a view showing the cross-sectional shape of a rotating body of a centrifugal separator used in Comparative Example 3.

FIG. 15 is a view showing the cross-sectional shape of a rotating body of a centrifugal separator used in Comparative Example 4.

Explanation of Reference Number

[0011]

| | |
|---|---|
| 1: | housing |
| 2: | rotating body (main body) |
| 3: | lid-like cover of the rotating body |
| 4: | slit |
| 5: | rotation shaft (drive shaft) |
| 6: | supply port of a used developer |
| 7: | discharge port of a treated developer |
| 8: | non-woven fabric |
| 9: | treated developer |
| 10: | suspended component (resin flocculate) |
| 11: | treated developer |
| 11': | treated developer which has been overflowed |
| 12: | circulating pump |
| 13: | circulating line |
| 14: | developer tank |
| 15: | flow rate control valve |
| 16: | feeding line |
| 17: | valve for opening/closing |
| 18: | centrifugal separator (device for recycling) |
| 19: | treated liquid line |
| 20: | treated liquid tank |
| 21: | inside disk |

Best Mode for Carrying Out the Invention

The present invention relates to a device for recycling a used water-based developer after development of a flexographic original printing plate having a photosensitive resin layer by using a centrifugal separator. The present invention is characterized in that a rotating body of the centrifugal separator has a slit provided in a side surface thereof so as to allow the used water-based developer after the centrifugation to flow out from an inside to an outside of the rotating body. Hereinbelow, a characteristic structure of the centrifugal separator of the recycling device according to the present invention will first be described, and then a developer to be treated by the recycling device according to the present invention will be described.

The recycling device according to the present invention includes a centrifugal separator, and a resin flocculate is separated from a used water-based developer by a rotating body of the centrifugal separator. A cross-sectional shape of the rotating body of the centrifugal separator in a vertical direction including a rotation shaft of the rotating body substantially has a cylindrical or truncated-conical outline. From the viewpoint of treatment efficiency, it is preferable that the rotating body of the centrifugal separator substantially has the cylindrical shape conventionally used. The resin flocculate having a low specific gravity contained in the used water-based developer is supplied to the inside of the rotating body of the centrifugal separator and then separated by centrifugation, and is therefore gathered as a suspended component on the side nearer to the rotation shaft of the rotating body and separated from the remaining water-based developer.

The characteristic feature of the recycling device according to the present invention is that the rotating body has a slit provided in a side surface thereof so as to allow the used water-based developer after the centrifugation to flow out from an inside to an outside of the rotating body. The slit plays the role of allowing a remaining water-based developer containing substantially no resin flocculate due to separation of the resin flocculate by centrifugal separation to flow out from the inside to the outside of the rotating body. In the present invention, such a slit makes it possible to efficiently take out a developer containing substantially no resin flocculate without providing an inside disk, thereby significantly improving the maintenance performance of the centrifugal separator.

The shape of the slit is not particularly limited. The slit does not need to continuously (over the entire surface) be provided as long as the flow of a liquid does not significantly reduce. Even separated slits may be provided. The separated slits may be provided by, for example, arranging rectangular or circular slits. The slit is preferably provided so as to be parallel to a rotational direction in terms of ease of production and the flow of a treated liquid. The number of slits is not particularly limited as long as at least one slit is provided. When a plurality of slits are provided, they are preferably arranged so as to rotationally symmetrically and evenly be distributed in the side surface of the rotating body of the centrifugal separator. A method for providing a slit in the side surface of the rotating body is not particularly limited. For example, the rotating body may be separated into a lid-like cover as an upper part and a main body as a lower part, and a continuous slit may be formed between the upper part and the lower part. More specifically, the lid-like cover is provided on the upper side of the main body of the rotating body, and a spacer having a thickness corresponding to a slit width is partially inserted between them and fixed with bolts, so that a gap can be created as a continuous slit between the cover and the main body of the rotating body. Alternatively, a plurality of separated slits may be provided by forming slit-shaped cuts having a necessary width in the side surface of the rotating body. However, in terms of ease of production, it is preferable to form a continuous slit by attaching a lid-like cover.

In the present invention, a ratio between the area of an opening of the slit and the internal volume of the rotating body is within a specific range so as to prevent clogging of the slit with a resin flocculate. Specifically, when a total area of the opening of the slit open to the inside of the rotating body is defined as $A \, cm^2$, and the internal volume of the rotating body is defined as $B \, cm^3$, a value of a slit opening area ratio (B/A) is in a range of 30000 to 140000, and preferably in a range of 35000 to 130000. If the slit opening area ratio (B/A) is less than the above lower limit, there is a fear that the removal ratio of a resin flocculate is lower, and if the slit opening area ratio exceeds the above upper limit, there is a fear that treatment efficiency is lower. It is to be noted that the internal volume of the rotating body can be calculated from the diameter and height of the rotating body.

In order to smoothly discharge a resin flocculate from the inside to the outside of the rotating body, it is not the number of slits but the ratio of the area of an opening of the slit to the internal volume of the rotating body that matters. When the internal volume of the rotating body is constant, formation of a large number of slits each having a small area and formation of a small number of slits each having a large area will produce the same effect as long as the total opening areas are the same. The direction of the slit is not particularly limited, either. All of a slit provided in a horizontal direction, a slit provided in an oblique direction, a slit having a step-like shape, and a slit having a shape such that a slit open area changes will produce the same effect. When the shape of the rotating body is fixed, as the value of a slit opening area ratio determined by dividing the internal volume of the rotating body by the area of a slit opening increases, the maximum flow rate of a treated liquid increases and the removal ratio of a resin flocculate tends to reduce. However, the relationship changes depending on the shape. For example, as the diameter of the rotating body increases, centrifugal force increases, and therefore the maximum flow rate of a treated liquid increases and the removal ratio of a resin flocculate also tends to increase. However, the area of opening of the slit facing the inside of the rotating body is preferably equal to or smaller than the area of opening of the slit facing the outside of the rotating body.

The used developer before treatment is supplied to the rotating body through a supply port and treated by centrifugal separation. The supply port is preferably provided at the bottom of the rotating body. Therefore, the opening of the slit is preferably provided at a position equal to or higher than a middle of a height of an inner wall of the rotating body. Excellent separation performance is achieved by providing the opening of the slit in a position far away from the developer supply port of the rotating body. This is because when the opening of the slit is provided in a position far away from the developer supply port of the rotating body, centrifugal separation treatment can be performed without the influence of the flow of the used developer before treatment that spreads laterally after charged into the rotating body.

The centrifugal separator used in the recycling device according to the present invention is a device that generates centrifugal force so as to perform separation between a solid and a liquid or separation between objects different in specific gravity. The centrifugal separator used in the present invention preferably performs centrifugal separation at a centripetal acceleration in a range of 200 to 4000 G. The amount of a developer that can be treated by the centrifugal separator depends on the volume of the inside of the centrifugal separator. When connected to a developing machine to directly treat a developer, the centrifugal separator should have an optimum throughput determined from the amount of the developer in the developing machine. When the amount of the developer is 60 liters, the throughput is preferably 0.3 liters or more per minute. When the amount of the developer is 200 liters, the throughput is preferably 1 liters or more per minute. It is to be noted that in the present invention, a flocculant may be added to a developer to enhance the effect of centrifugal separation. However, it is preferred that a flocculant is not used so as to allow reuse of a developer.

In order to easily take out a resin flocculate, the recycling device according to the present invention may include a non-woven fabric or a bag made of a resin sheet provided along the inner wall of the rotating body of the centrifugal separator. By providing such a non-woven fabric or a bag made of a resin sheet along the inner wall of the rotating body, it is possible to take a resin flocculate accumulated inside the rotating body out of the rotating body together with the non-woven fabric or the bag made of a resin sheet. In terms of the efficiency of taking out a resin flocculate, a non-woven fabric is more preferred. In the case of a bag made of a resin sheet, it is necessary to fix the bag along the inner wall surface of the rotating body.

The non-woven fabric to be used may be a commercially-available non-woven fabric. In the present invention, by providing the non-woven fabric in such a manner that the non-woven fabric covers the inner wall of the rotating body, it is also expected that a developer separated from a resin flocculate by centrifugal force can easily move into a liquid flow channel through the non-woven fabric. The non-woven fabric to be used is not particularly limited as long as it can stand alone along the side surface of the rotating body of the centrifugal separator, does not interfere with the flow of a treated developer, and does not cause clogging with a resin flocculate. Centrifugal separation can be performed without the non-woven fabric. However, it is better to use the non-woven fabric because the suspended component can easily be removed thereby. Examples of the material of the non-woven fabric include, but are not limited to, polyester, polyamide, polyurethane, polyethylene, polypropylene, polyolefin, vinyl chloride, and cellulose. Further, in order to improve self-supportability of the non-woven fabric, a thermal adhesive fiber may be blended to the extent that the thermal adhesive fiber does not interfere with the flow of a treated developer. The thickness of the non-woven fabric is preferably 5 mm or more and more preferably 10 mm or more. If the thickness is too small, it is difficult for the non-woven fabric to stand alone. On the other hand, the thickness is preferably 80 mm or less and more preferably 40 mm or less. If the thickness is too large, a space for holding the suspended component reduces. The weight per unit area of the non-woven fabric is preferably 100 $g/m^2$ or more and more preferably 200 $g/m^2$ or more. If the weight per unit area is too small, the strength of the non-woven fabric is weak. On the other hand, the weight per unit area is preferably 800 $g/m^2$ or less and more preferably 400 $g/m^2$ or less. If the weight per unit area is too large, the non-woven fabric interferes with the flow of a liquid. A particularly preferred example of the non-woven fabric is a non-woven fabric made of polyethylene, polypropylene, polyester, or cellulose and having a weight per unit area of 200 to 500 $g/m^2$ and a thickness of 10 to 30 mm. Regarding the bag made of a resin sheet, a bag made of a resin such as polyethylene may be used. The bag made of a resin sheet preferably has fine pores, and should be provided in such a manner that the bag does not block the treated liquid flow channel of the slit. The resin sheet may have a thickness of 0.02 to 0.5 mm.

Hereinbelow, a developer to be treated by the recycling device according to the present invention will be described. This developer is a used water-based developer after development of a flexographic original printing plate having a photosensitive resin layer containing a water-dispersible synthetic rubber-based polymer. Such a used developer contains a resin flocculate derived from a component of the photosensitive resin layer in an unexposed area of the flexographic original printing plate. In the present invention, a water-dispersible synthetic rubber-based polymer is used as a main component of the photosensitive resin layer. Therefore, the resin flocculate in the used developer contains a large amount of the water-dispersible synthetic rubber-based polymer. Such a water-dispersible synthetic rubber-based polymer has a specific gravity lower than that of water, and therefore can easily be separated from the remaining water-based developer by centrifugal separation so as to form a suspended component.

The water-dispersible synthetic rubber-based polymer is used for imparting appropriate rubber elasticity to the photosensitive resin layer. A conventionally-known rubber component can be used as the water-dispersible synthetic rubber-based polymer. The water-dispersible synthetic rubber-based polymer is preferably solid at room temperature for imparting rubber elasticity. Specific examples of the water-dispersible synthetic rubber-based polymer include polybutadiene, polychloroprene, polyacrylonitrile-butadiene, polyacrylic, epichlorohydrin, polyurethane, polyisoprene, a polystyrene-isoprene copolymer, a polystyrene-butadiene copolymer, a methylmethacrylate-butadiene copolymer, an ethylenepropylene copolymer, a butyl polymer, chlorinated polyethylene, and a polymer obtained by copolymerization of such a polymer and another component such as acrylic acid or methacrylic acid.

Among them, a water-dispersible synthetic rubber-based polymer having a butadiene skeleton and/or a styrene skeleton is preferable in terms of developability and physical properties. A water-dispersible latex is more preferable. The water-dispersible latex may be a latex having a cross-linked structure expressed by a gelation degree in its molecule. Such a latex having a cross-linked structure in its molecule is preferably a hydrophobic polymer obtained from a water-dispersible latex having a weight-average gelation degree of 20 to 80%. They may be used singly or in combination of two or more of them. It is to be noted that the water-dispersible latex is a stable suspension in which rubber polymer fine particles are dispersed in water. The polymer is obtained by removing water from the water-dispersible latex.

In order to improve physical properties and water resistance, the photosensitive resin layer of the flexographic original printing plate may contain a water-insoluble synthetic rubber-based polymer to the extent that it does not adversely affect performances. Examples of the water-insoluble synthetic rubber-based polymer include polybutadiene, polychloroprene, polyacrylonitrile-butadiene, polyurethane, polyisoprene, a polystyrene-isoprene copolymer, and a polystyrene-butadiene copolymer.

The photosensitive resin layer of the flexographic original printing plate may contain a water-soluble or water-dispersible polymer other than the water-dispersible synthetic rubber-based polymer. Examples of the water-soluble or water-dispersible polymer include a water-soluble polyamide or a water-dispersible polyamide obtained by introducing a hydrophilic group into a polyamide, a partially-saponified polyvinyl acetate and a derivative thereof, and an anionic acrylic polymer.

In such a used developer after the development of a flexographic original printing plate having a photosensitive resin layer, the water-dispersible synthetic rubber-based polymer is dispersed in the developer. Therefore, a polymer concentration in the developer does not rapidly increase. Further, the water-dispersible property of the synthetic rubber-based polymer is suitable for waste liquid treatment based on centrifugal separation.

The photosensitive resin composition of the flexographic original printing plate contains a photopolymerizable unsaturated monomer compound and a photopolymerization initiator in addition to the above-described water-dispersible synthetic rubber-based polymer. These additional components are well known to those skilled in the art, and are therefore not described in detail here.

The flexographic original printing plate includes a support in addition to the photosensitive resin layer, and the photosensitive resin layer may be provided on the support. Further, a protective layer and an infrared-sensitive layer may be provided on the photosensitive resin layer. These elements are well known to those skilled in the art, and are therefore not described in detail here.

The developer to be treated by the recycling device according to the present invention is a water-based developer mainly containing water. The water-based developer may be water alone or an aqueous solution obtained by adding a water-soluble development accelerator to water. Examples of the development accelerator include a surfactant, an acid, a base, and a salt. Examples of the surfactant include a cationic surfactant, an anionic surfactant, and a nonionic surfactant. Examples of the acid include inorganic acids such as sulfuric acid, nitric acid, and phosphoric acid, and organic acids such as formic acid, acetic acid, oxalic acid, succinic acid, citric acid, maleic acid, and para-toluenesulfonic acid. Examples of the base include lithium hydroxide, sodium hydroxide, potassium hydroxide, and calcium hydroxide. Examples of the salt include sodium carbonate and sodium silicate. From the viewpoint of developing speed, a water-soluble development accelerator is preferred. As the development accelerator, commercially-available soap or detergent may be used. The development accelerator may be a combination of two or more of a surfactant, an acid, a base, and a salt. An optimum composition of the development accelerator may be determined depending on the components of the photosensitive resin composition.

Further, the water-based developer may contain a water-soluble organic solvent in addition to water. Examples of such an organic solvent include methanol, ethanol, isopropyl alcohol, cellosolve, glycerin, ethylene glycol, and polyethylene glycol.

Further, a defoaming agent may be added to the water-based developer so as to prevent foam generation. The defoaming agent is not particularly limited as long as it is soluble in water. Examples of a component of the defoaming agent include a higher alcohol, a fatty acid derivative, silica, alumite, and silicone.

Hereinbelow, the recycling device according to the present invention will specifically be described with reference to the drawings.

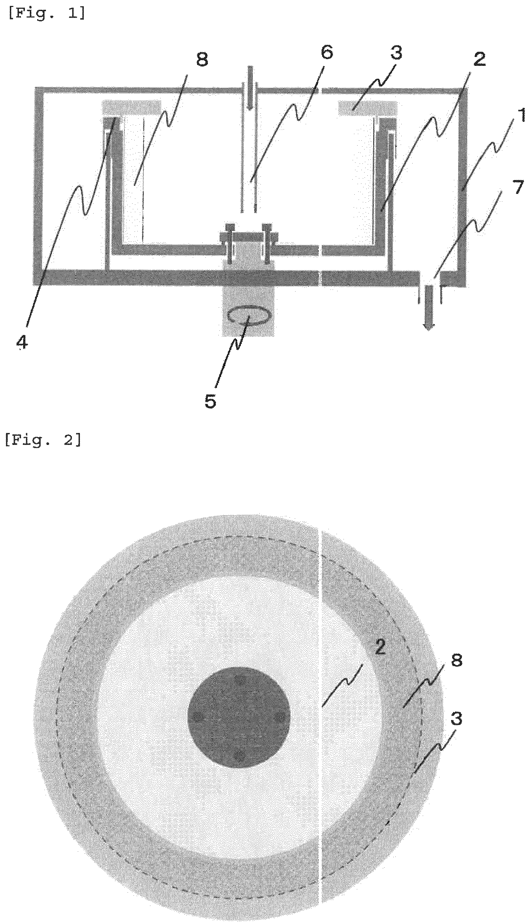

FIG. 1 is a schematic view of an embodiment of the recycling device according to the present invention. In FIG. 1, reference numeral 1 denotes a housing, reference numeral 2 denotes a rotating body, reference numeral 3 denotes a lid-like cover of the rotating body, reference numeral 4 denotes a slit formed between the rotating body 2 and the lid-like cover 3, reference numeral 5 denotes a rotation shaft (drive shaft) of the rotating body, reference numeral 6 denotes a supply port of a used developer to be treated, reference numeral 7 denotes a discharge port of a treated developer, and reference numeral 8 denotes a non-woven fabric provided in such a manner that the non-woven fabric covers the inner wall of the rotating body 2 along the entire circumference of the rotating body 2.

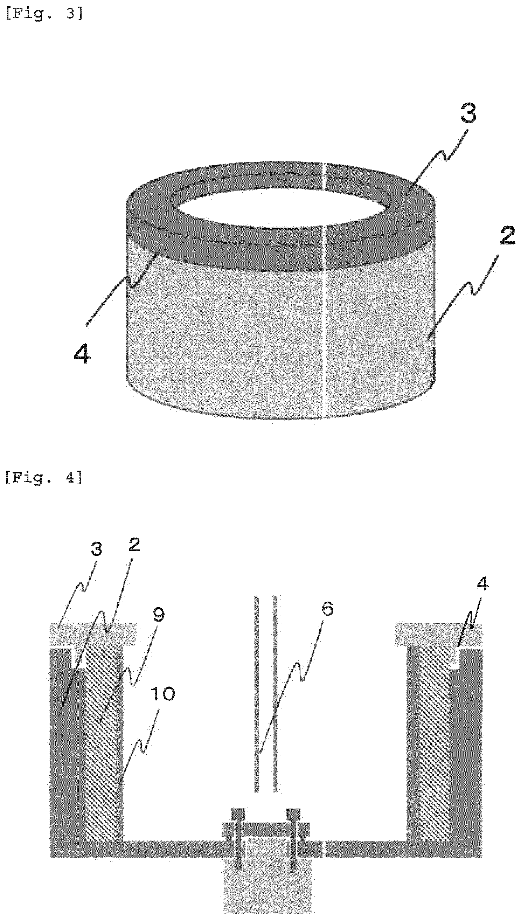

In the embodiment shown in FIG. 1, the cross-sectional shape of the rotating body 2 in a vertical direction including the rotation shaft 5 of the rotating body substantially has a cylindrical outline. In the present invention, a used developer supplied through the supply port 6 is separated into a resin flocculate having a low specific gravity and a treated developer having a high specific gravity, from which the resin flocculate has been removed, in the rotating body 2 of the centrifugal separator. As shown in FIGS. 2 and 3, the rotating body 2 includes a basket-shaped main body. A donut-shaped lid-like cover 3 is attached onto the main body. A spacer is inserted between the main body and the cover and fixed with screws at four positions to create a gap (slit 4). The rotating body is connected to a motor through the rotation shaft (drive shaft). Therefore when the rotating body is rotated, a centripetal acceleration is generated which results in generation of an outward centrifugal force. A used developer is supplied into the rotating body through the supply port. When supplied into the rotating body, the used developer is soon attached to the side surface of the rotating body. Then, as shown in FIG. 4, the used developer is separated by centrifugal force into a suspended component 10 containing a resin flocculate having a low specific gravity and a treated developer 9 having a high specific gravity. More specifically, a water-dispersible synthetic rubber-based polymer derived from a photosensitive resin layer in an unexposed area of an original printing plate has a specific gravity lower than that of water and is therefore separated as the suspended component 10 on the inner side (center side) of the rotating body, and the treated developer 9 having a high specific gravity is separated on the outer side of the rotating body (inner wall side of the rotating body). Water pressure is exerted on the inner wall of the rotating body by centrifugal force, and therefore the treated developer 9 having a high specific gravity present on the inner wall side of the rotating body flows out through the slit 4. The effluent liquid passes through the slit by the force of water pressure, and is therefore ejected in the form of a spray. The ejected treated developer is collected in the housing 1 shown in FIG. 1 and led to the discharge port 7. The treated developer discharged from the discharge port can be used as a recycled developer because the resin flocculate has been removed therefrom.

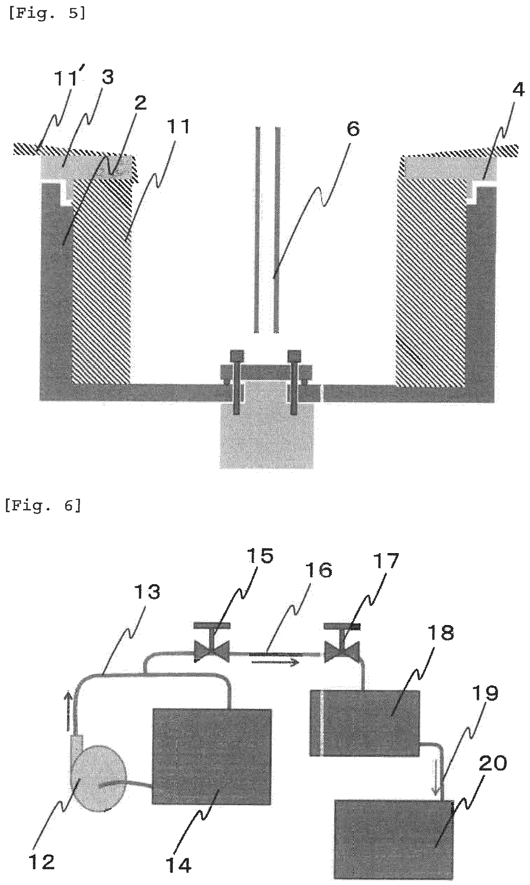

When the non-woven fabric 8 is previously provided along the inner wall of the rotating body, the resin flocculate 10 is gradually accumulated on the non-woven fabric. If a space inside the rotating body is filled with the resin flocculate, as shown in FIG. 5, a phenomenon (overflow) occurs in which a treated developer 11' flows over the lid-like cover 3 constituting an upper part of the rotating body. Therefore, before such overflow occurs, supply of a developer is stopped, the centrifugal separator is operated for a while for dewatering and then stopped, and the non-woven fabric is taken out so as to discharge the resin flocculate. After the resin flocculate is removed, a new non-woven fabric is provided and centrifugal separation is restarted.

It is to be noted that in the present embodiment, bolted connection between the rotating body and the lid-like cover of the rotating body is used as an example of a method for forming a slit, but a method other than bolted connection may be used. For example, a slit may be formed by cutting a rotating body integrally formed with a lid-like cover. The same effect can be obtained by forming a plurality of holes instead of a slit.

In the present embodiment, the rotating body of the centrifugal separator has been described with reference to a case where the rotating body has a vertical structure, but the same effect can be obtained even when the rotating body has a horizontal structure.

The recycling device according to the present invention can suitably be used as an effective alternative to a conventional recycling device in a conventionally-known apparatus for developing a flexographic original printing plate including a developer recycling device.

Examples

The present invention will now be illustrated in more detail by way of the following Examples although the present invention is not limited to these Examples. The scope of the invention is restricted by the appended claims.

<Preparation of photosensitive resin original printing plate>

(1) Preparation of photosensitive resin composition

Photosensitive resin composition A:

First, 91 parts by mass of butadiene latex as a water-dispersible synthetic rubber-based polymer (manufactured by Zeon Corporation, LX111NF, solid concentration: 55%), 15 parts by mass of oligobutadiene acrylate as a photopolymerizable unsaturated monomer compound (manufactured by Kyoeisha Chemical Co., Ltd., ABU-3, molecular weight: 2700), 10 parts by mass of lauryl methacrylate, 10 parts by mass of trimethylolpropane trimethacrylate, 1 part by mass of benzyldimethylketal as a photopolymerization initiator, 20 parts by mass of PFT-3 manufactured by Kyoeisha Chemical Co., Ltd. (polymer having a urethaneurea structure and a molecular weight of about 20,000, solid concentration: 25%) as a hydrophilic polymer, 0.1 part by mass of hydroquinone monomethyl ether as a polymerization inhibitor, and 9 parts by mass of liquid butadiene as a plasticizer were mixed in a container together with 5 parts by mass of toluene, and then kneaded at 105°C using a pressure kneader. Then, toluene and water were distilled away under reduced pressure so as to obtain a photosensitive resin composition A.

Photosensitive resin composition B:

First, 56.4 parts by mass of butadiene latex as a water-dispersible synthetic rubber-based polymer (manufactured by Zeon Corporation, LX111NF, solid concentration: 55%), 10 parts by mass of polybutadiene-terminated diacrylate (manufactured by OSAKA ORGANIC CHEMICAL INDUSTRY LTD., BAC-45) as a photopolymerizable unsaturated monomer compound, and 10 parts by mass of an acrylic monomer (1,9-nonanediol dimethacrylate) were mixed, and moisture was evaporated in a drier heated at 120°C for 2 hours so as to obtain a mixture. This mixture, 6 parts by mass of butadiene rubber (manufactured by Zeon Corporation, Nipol BR1220), 7 parts by mass (4 parts by mass as solid matter) of a surfactant (manufactured by NOF CORPORATION, NONION TA-405), and 10 parts by mass of liquid butadiene as a plasticizer were kneaded in a kneader for 45 minutes. Then, 0.2 part by mass of hydroquinone monomethyl ether as a polymerization inhibitor and 1 part by mass of benzyldimethylketal as a photopolymerization initiator were charged into the kneader, and the thus obtained mixture was kneaded for 5 minutes so as to obtain a photosensitive resin composition B.

Photosensitive resin composition C:

First, 100 parts by mass of carboxy-modified methylmethacrylate as a water-dispersible synthetic rubber-based polymer (manufactured by NIPPON A&L INC., MR174, solid concentration: 50%), 15 parts by mass of oligobutadiene acrylate as a photopolymerizable unsaturated monomer compound (manufactured by Kyoeisha Chemical Co., Ltd., ABU-3, molecular weight: 2700), 10 parts by mass of lauryl methacrylate, 10 parts by mass of trimethylolpropane trimethacrylate, 1 part by mass of benzyldimethylketal as a photopolymerization initiator, 20 parts by mass of PFT-3 manufactured by Kyoeisha Chemical Co., Ltd. (polymer having a urethaneurea structure and a molecular weight of about 20,000, solid concentration: 25%) as a hydrophilic polymer, 0.1 part by mass of hydroquinone monomethyl ether as a polymerization inhibitor, and 9 parts by mass of liquid butadiene as a plasticizer were mixed in a container together with 5 parts by mass of toluene, and then kneaded at 105°C using a pressure kneader. Then, toluene and water were distilled away under reduced pressure so as to obtain a photosensitive resin composition C.

Photosensitive resin composition D:

First, 71 parts by mass of styrene-butadiene latex as a water-dispersible synthetic rubber-based polymer (manufactured by Zeon Corporation, C4850, solid concentration: 70%), 15 parts by mass of oligobutadiene acrylate as a photopolymerizable unsaturated monomer compound (manufactured by Kyoeisha Chemical Co., Ltd., ABU-3, molecular weight: 2700), 10 parts by mass of lauryl methacrylate, 10 parts by mass of trimethylolpropane trimethacrylate, 1 part by mass of benzyldimethylketal as a photopolymerization initiator, 20 parts by mass of PFT-3 manufactured by Kyoeisha Chemical Co., Ltd. (polymer having a urethaneurea structure and a molecular weight of about 20,000, solid concentration: 25%) as a hydrophilic polymer, 0.1 part by mass of hydroquinone monomethyl ether as a polymerization inhibitor, and 9 parts by mass of liquid butadiene as a plasticizer were mixed in a container together with 5 parts by mass of toluene, and then kneaded at 105°C using a pressure kneader. Then, toluene and water were distilled away under reduced pressure so as to obtain a photosensitive resin composition D.

(2) Preparation of coating liquid for the protective layer

A low-saponification polyvinyl alcohol (PVA405 from Kuraray Co., Ltd.), a plasticizer (SANFLEX SE270 from Sanyo Chemical Industries, Ltd., aliphatic polyhydric alcohol-based polyether polyol, with 85% solid concentration) and an NBR latex (SX1503A from Nippon Zeon, with 42% solid concentration) were dissolved in a water/isopropanol mixed solution, while adjusting the weight ratio of solid content to 35/35/30, thereby preparing a coating liquid for the protective layer.

(3) Preparation of coating liquid for the infrared-sensitive layer

A carbon black dispersion (AMBK-8 from Orient Chemical Industries, Co., Ltd.) and a copolymerized polyamide (PA223 from TOYOBO Co., Ltd.) were dissolved in a methanol/ethanol/isopropanol mixed solution while adjusting the weight ratio of solid content to 63/37, thereby preparing a coating liquid for the infrared-sensitive layer.

(4) Preparation of multilayered film

The coating liquid for the infrared-sensitive layer prepared in the (3) was coated on a 100 μm thick PET film having both surfaces release-treated, with use of a suitable type of bar coater, and the coating was dried at 120°C for 5 minutes, thereby overlaying a 1.5 μm thick infrared-sensitive layer on the PET film. The optical density at this time was found to be 2.3. The optical density was measured with use of a black-and-white transmission densitometer DM-520 (from Dainippon Screen Mfg. Co., Ltd.). Next, the coating liquid for the protective layer prepared in the (2) was coated on the infrared-sensitive layer with use of a suitable type of bar coater, and the coating was dried at 120°C for 5 minutes, thereby forming a multilayered film having the 1.5 μm thick infrared-sensitive layer and a 0.5 μm thick protective layer stacked in this order on the PET film.

(5) Preparation of photosensitive resin printing original plates A, B, C and D each composed of each of the photosensitive resin composition A, B, C, D and the multilayered film

The photosensitive resin composition A prepared in the (1) was placed on a 100 μm thick PET film having a copolymerized polyester-based adhesive coated thereon, and the multilayered film prepared in the (4) was further overlaid thereon. The stack was laminated at 100°C with use of a heat press machine, thereby obtaining a flexographic printing original plate composed of the PET support, the adhesive layer, the photosensitive resin layer, the protective layer, the infrared-sensitive layer and the release-treated PET protective film (cover film). A total thickness of the plate was 1.14 mm. The photosensitive resin printing original plates B, C and D were prepared in the same way as in the photosensitive resin printing original plate A, except that the photosensitive resin composition A was changed to the photosensitive resin composition B, C or D, respectively.

<Preparation of a used water-based developer after development of the flexographic original printing plate>

Sodium oleate as a development accelerator was dissolved in tap water in an amount of 1% by mass of the total amount of a developer. In this way, a water-based developer was prepared. In this water-based developer, the flexographic original printing plate, from which the cover film had been removed, was developed in a developing machine by brushing the plate with a brush made of nylon filaments having a diameter of 200 μm. In this way, a used water-based developer after development of the flexographic original printing plate was prepared. At this time, the concentration of the photosensitive resin composition in the water-based developer was adjusted to 5% by mass.

<Connection method of a centrifugal separator, a developer tank, and a treated liquid tank>

A developer tank 14 for storing 50 L of the water-based developer, a circulating pump 12 for circulating the developer stored in the tank, a flow rate control valve 15, a centrifugal separator 18, and a treated liquid tank 20 were connected as shown in FIG. 6.

<Measurement method of an NV value representing a non-volatile content>

The centrifugal separator, the developer tank, and the treated liquid tank were connected by the above connection method. A developer prepared in accordance with the above-described method for preparing a used water-based developer was treated in the centrifugal separator by centrifugal separation at a rotation speed such that a predetermined centripetal acceleration was achieved. A treated developer was stored in the treated liquid tank. A liquid sampled from the treated liquid tank was defined as a sample after treatment. A liquid sampled from the developer tank before treatment was defined as a sample before treatment. Two grams of the sample before treatment and two grams of the sample after treatment were each placed in an aluminum foil cup and dried in a vacuum drier at 80°C for 2 hours. An NV value [%] representing a non-volatile content was measured. Mass measurement was performed using an electronic precision balance. A calculation formula is as follows.

NV value [%] = [(mass after being dried) - (mass of the aluminum foil cup)] / [(mass before being dried) - (mass of the aluminum foil cup)] × 100

<Evaluation of a resin flocculate removal ratio>

A resin concentration was determined from the measured NV value by theoretical calculation. A calculation formula is as follows.

Resin concentration [%] = [(NV value) - (amount of added sodium oleate) (1% by mass)]

A resin flocculate removal ratio was calculated from the resin concentration of the sample before treatment and the resin concentration of the sample after treatment. A calculation formula is as follows.

Resin flocculate removal ratio [%] = [(resin concentration of the sample before treatment) - (resin concentration of the sample after treatment)] / (resin concentration of the sample before treatment) $\times$ 100

<Evaluation of a flow rate>

The centrifugal separator, the developer tank, and the treated liquid tank were connected by the above-described connection method. The flow rate control valve was opened so as to discharge the treated developer from the discharge port of the centrifugal separator. The discharged treated developer was poured into a cup for 10 seconds. The volume [L] of the developer placed in the cup was measured using a measuring cylinder. A value 6 times the measured volume was defined as a flow rate per minute [L/min].

Example 1

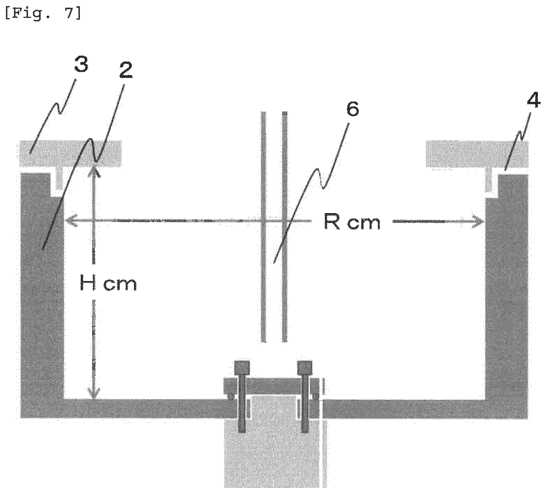

A used water-based developer was prepared using the photosensitive resin original printing plate A in accordance with the method for preparing a used water-based developer. A non-woven fabric (made of polyester, thickness: 20 mm, weight per unit area: 380 g/m$^2$) (FIG. 1, FIG. 2) was provided inside a rotating body of a centrifugal separator shown in FIG. 7 [inner diameter of cylindrical rotating body R = 30 cm, height of cylindrical rotating body H = 20 cm, closed bottom type] in such a manner that the non-woven fabric covers the inner wall of the rotating body along the entire circumference thereof. A spacer having a thickness of 0.03 mm was inserted between a lid-like cover of the rotating body and a main body of the rotating body. The lid-like cover of the rotating body was fixed with screws so as to adjust a total slit opening area A. The centrifugal separator was connected to a developer tank and a treated liquid tank by the above-described connection method, and a flow rate was measured. Then, the centrifugal separator was operated. A flow rate wherein overflow (FIG. 5) did not occur when the developer was flowed in an amount two times as large as the volume of the rotating body was defined as a maximum throughput. The centrifugal separator was stopped after the developer was flowed in an amount two times as large as the volume of the rotating body at the maximum throughput, and a resin flocculate removal ratio was evaluated by the above-described method. The result is shown in Table 1.

Examples 2 to 13 and Comparative Examples 1 to 4

An experiment was performed in the same manner as in Example 1 except that the structure of the centrifugal separator and conditions of centrifugal separation were changed as shown in Table 1. The result is shown in Table 1.

[Table 1]

|  |  | Example 1 | Example 2 | Example 3 | Example 4 |
|---|---|---|---|---|---|
| Properties of centrifugal separator | cross-sectional shape of rotating body | substantially cylindrical | substantially cylindrical | substantially cylindrical | substantially cylindrical |
|  | position and shape of slit | FIG. 7 (upper portion/ step-like) | FIG. 7 (upper portion/ step-like) | FIG. 7 (upper portion/ step-like) | FIG. 7 (upper portion/ step-like) |
|  | number of slit | 1 (continuous) | 1 (continuous) | 1 (continuous) | 1 (continuous) |
|  | spacer thickness [mm] | 0.03 | 0.03 | 0.03 | 0.05 |
|  | diameter of rotating body [cm] | 30 | 30 | 50 | 50 |
|  | height of rotating body [cm] | 20 | 15 | 30 | 30 |
|  | rotation speed [rpm] | 2000 | 2000 | 1500 | 1500 |
|  |  |  |  |  |  |
|  | total area of opening of slit A [cm$^2$] | 0.28 | 0.28 | 0.47 | 0.79 |
|  | internal volume of rotating body of centrifugal separator B [cm$^3$] | 14137 | 10603 | 58905 | 58905 |
|  | slit opening area ratio (B/A) | 50000 | 37500 | 125000 | 75000 |
|  | centripetal acceleration [G] | 671 | 671 | 629 | 629 |
|  | non-woven fabric | present | present | present | present |
| Evaluation | resin flocculate removal ratio [%] | 82 | 78 | 85 | 75 |
|  | maximum throughput [L/min] | 2.2 | 2.4 | 4.8 | 10.0 |

|  |  | Example 5 | Example 6 | Example 7 | Example 8 |
|---|---|---|---|---|---|
| Properties of centrifugal separator | cross-sectional shape of rotating body | substantially cylindrical | substantially cylindrical | substantially cylindrical | substantially cylindrical |
|  | position and shape of slit | FIG. 8 (middle portion/ step-like) | FIG. 7 (upper portion/ step-like) | FIG. 7 (upper portion/ step-like) | FIG. 7 (upper portion/ step-like) |
|  | number of slit | 1 (continuous) | 1 (continuous) | 1 (continuous) | 1 (continuous) |
|  | spacer thickness [mm] | 0.03 | 0.03 | 0.03 | 0.03 |
|  | diameter of rotating body [cm] | 30 | 30 | 30 | 30 |
|  | height of rotating body [cm] | 20 | 20 | 20 | 20 |
|  | rotation speed [rpm] | 2000 | 3000 | 1600 | 2000 |
|  | total area of opening of slit A [cm$^2$] | 0.28 | 0.28 | 0.28 | 0.28 |
|  | internal volume of rotating body of centrifugal separator B [cm$^3$] | 14137 | 14137 | 14137 | 14137 |
|  | slit opening area ratio (B/A) | 50000 | 50000 | 50000 | 50000 |
|  | centripetal acceleration [G] | 671 | 1509 | 429 | 671 |
|  | non-woven fabric | present | present | present | absent |

(continued)

|  |  | Example 5 | Example 6 | Example 7 | Example 8 |
|---|---|---|---|---|---|
| Evaluation | resin flocculate removal ratio [%] | 75 | 84 | 75 | 82 |
|  | maximum throughput [L/min] | 2.4 | 3.8 | 1.2 | 2.4 |

|  |  | Example 9 | Example 10 | Example 11 | Example 12 |
|---|---|---|---|---|---|
| Properties of centrifugal separator | cross-sectional shape of rotating body | substantially cylindrical | substantially truncated-conical | substantially cylindrical | substantially cylindrical |
|  | position and shape of slit | FIG. 9 (lower portion/ step-like) | FIG. 10 (upper portion/ horizontal) | FIG. 11 (upper portion/ oblique) | FIG. 12 (upper portion/ horizontal) |
|  | number of slit | 1 (continuous) | 1 (continuous) | 1 (continuous) | 4 |
|  | spacer thickness [mm] | 0.03 | 0.03 | 0.03 | 0 |
|  | diameter of rotating body [cm] | 30 | 30/20 | 30 | 30 |
|  | height of rotating body [cm] | 20 | 20 | 20 | 20 |
|  | rotation speed [rpm] | 2000 | 2000 | 2000 | 2000 |
|  | total area of opening of slit A [cm$^2$] | 0.28 | 0.28 | 0.28 | 0.28 |
|  | internal volume of rotating body of centrifugal separator B [cm$^3$] | 14137 | 9948 | 14137 | 14137 |
|  | slit opening area ratio (B/A) | 50000 | 35185 | 50000 | 50000 |
|  | centripetal acceleration [G] | 671 | 671 | 671 | 671 |
|  | non-woven fabric | present | present | present | present |
| Evaluation | resin flocculate removal ratio [%] | 70 | 77 | 82 | 82 |
|  | maximum throughput [L/min] | 2.4 | 2.3 | 2.2 | 2.2 |

| | | Example 13 | Comparative Example 1 | Comparative Example 2 | Comparative Example 3 |
|---|---|---|---|---|---|
| Properties of centrifugal separator | cross-sectional shape of rotating body | substantially cylindrical | substantially cylindrical | substantially cylindrical | substantially cylindrical |
| | position and shape of slit | FIG. 13 (upper portion/ horizontal) | FIG. 7 (upper portion/ step-like) | FIG. 7 (upper portion/ step-like) | FIG. 14 (without slit / with inside disk) |
| | number of slit | 18 | 1 (continuous) | 1 (continuous) | 0 |
| | spacer thickness [mm] | 0 | 0.01 | 0.04 | 0 |
| | diameter of rotating body [cm] | 30 | 30 | 30 | 30 |
| | height of rotating body [cm] | 20 | 20 | 15 | 20 |
| | rotation speed [rpm] | 2000 | 2000 | 2000 | 2000 |
| | total area of opening of slit A [cm$^2$] | 0.28 | 0.09 | 0.38 | 0 |
| | internal volume of rotating body of centrifugal separator B [cm$^3$] | 14137 | 14137 | 10603 | 14137 |
| | slit opening area ratio (B/A) | 50000 | 150000 | 28125 | - |
| | centripetal acceleration [G] | 671 | 671 | 671 | 671 |
| | non-woven fabric | present | present | present | present |
| Evaluation | resin flocculate removal ratio [%] | 82 | 90 | 60 | 50 |
| | maximum throughput [L/min] | 2.2 | 0.4 | 4.2 | 2.0 |

| | | Comparative Example 4 |
|---|---|---|
| Properties of centrifugal separator | cross-sectional shape of rotating body | substantially cylindrical |
| | position and shape of slit | FIG. 15 (without slit) |
| | number of slit | 0 |
| | spacer thickness [mm] | 0 |
| | diameter of rotating body [cm] | 30 |
| | height of rotating body [cm] | 20 |
| | rotation speed [rpm] | 2000 |
| | total area of opening of slit A[cm$^2$] | 0 |
| | internal volume of rotating body of centrifugal separator B [cm$^3$] | 14137 |
| | slit opening area ratio (B/A) | - |
| | centripetal acceleration [G] | 671 |
| | non-woven fabric | present |
| Evaluation | resin flocculate removal ratio [%] | 10 |
| | maximum throughput [L/min] | 2.0 |

Examples 14 to 16

Centrifugal separation treatment was performed in the same manner as in Example 1 except that the photosensitive resin original printing plate B, C, or D was used instead of the photosensitive resin original printing plate A. The result is shown in Table 2.

[Table 2]

|  |  | Example 1 | Example 14 | Example 15 | Example 16 |
|---|---|---|---|---|---|
| Photosensitive resin original printing plate |  | A | B | C | D |
| Evaluation | resin flocculate removal ratio [%] | 82 | 81 | 82 | 78 |
|  | maximum throughput [L/min] | 2.2 | 2.2 | 2.2 | 2.2 |

Tables 1 and 2 reveal that all the Examples 1 to 16 satisfying the requirements of the present invention achieve both a high resin flocculate removal ratio and a high maximum throughput.

More specifically, Examples 1 and 2 are examples in which the slit opening area ratio is within a particularly preferred range, and therefore a high resin flocculate removal ratio and a high maximum throughput are achieved.

In Example 3, the diameter of the cylindrical rotating body is larger than that in Example 1, and therefore a higher resin flocculate removal ratio is achieved due to a higher centrifugal force acting on the treated liquid.

In Example 4, the slit opening area ratio is lower than that in Example 3, and therefore the resin flocculate removal ratio is lower, but the maximum throughput is higher.

The results of Example 5 reveal that excellent centrifugal separation treatment can be performed even when the slit is provided not in the upper portion but in the middle portion of the cylindrical rotating body.

The results of Examples 6 and 7 reveal that even when the centripetal acceleration is increased or decreased as compared to Example 1, centrifugal separation can adequately be performed as long as the acceleration of the centrifugal separator is within a usual range.

Example 8 is an example not using a non-woven fabric, but exhibits excellent results as in the case of Example 1. This reveals that excellent centrifugal separation treatment can be performed even without using a non-woven fabric (although absence of the non-woven fabric is inconvenient in terms of taking out of a resin flocculate).

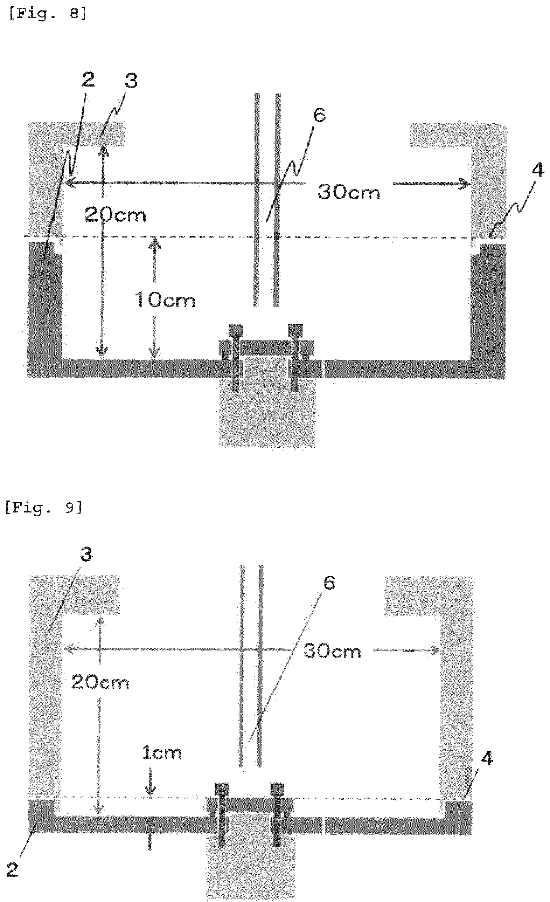

In Example 9, the opening of the slit is located in the lower portion of the cylindrical rotating body as shown in FIG. 9, and therefore the resin removal ratio is slightly lower than that in Example 1, but excellent centrifugal separation can still be performed due to the slit.

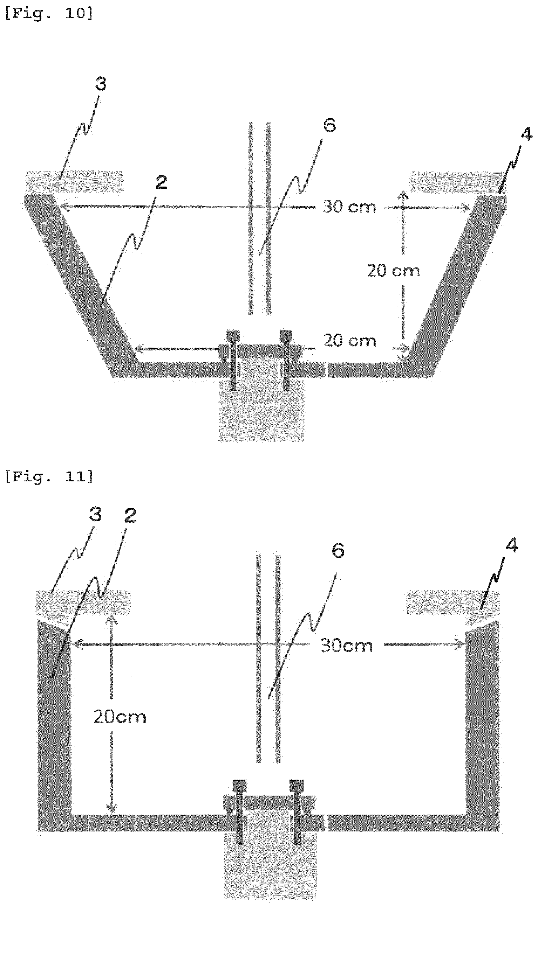

In Example 10, a truncated-conical rotating body as shown in FIG. 10 is used instead of the cylindrical rotating body. The resin flocculate removal ratio is slightly lower than that in Example 1, but excellent results are obtained even when the rotating body has such a shape.

In Example 11, as shown in FIG. 11, a slit is formed so as to have an oblique cross-section so that the main body of the cylindrical rotating body has a mortar-shaped top. The angle of the mortar-shaped top with respect to the horizontal direction was 30 degrees. Even when the main body of the cylindrical rotating body has such a shape, excellent results are obtained as in the case of Example 1.

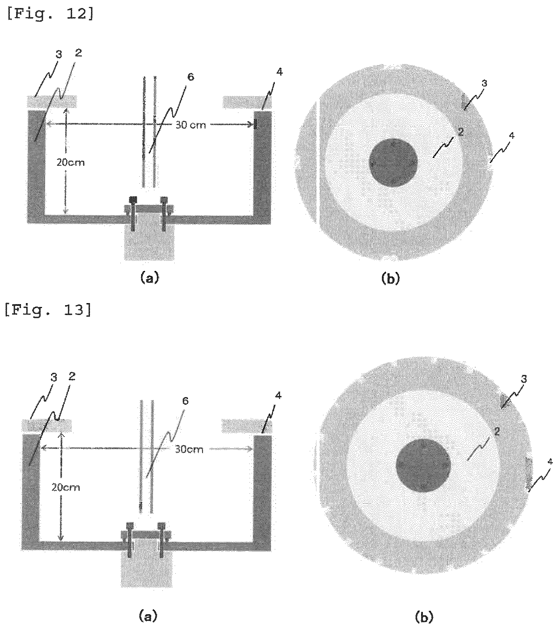

In Example 12, the rotating body has a structure having slits at four positions as shown in FIG. 12. Such a structure was formed not by a method in which a spacer was inserted to form a continuous gap between the lid-like cover of the cylindrical rotating body and the main body of the cylindrical rotating body as in the case of Example 1 or the like, but by a method using no spacer in which grooves having a depth of 0.7 mm and a width of 10 mm were previously formed at four positions in the top of the cylindrical rotating body so that openings were provided between the cylindrical rotating body and the lid-like cover of the cylindrical rotating body. Even when the number of slits is changed as described above, the diameter of the cylindrical rotating body and the value of the slit opening area ratio are not changed as compared to Example 1, and therefore the same evaluation results are obtained.

In Example 13, the rotating body has a structure having the openings of the slit at eighteen positions as shown in FIG. 13. The number of openings was changed in the same manner as in Example 12. Specifically, the structure shown in FIG. 13 was formed by a method in which grooves having a depth of 0.4 mm and a width of 4 mm were previously formed at eighteen positions in the top of the cylindrical rotating body so that openings were provided between the cylindrical rotating body and the lid-like cover of the cylindrical rotating body. Even when the number of slits is changed as described above, the diameter of the cylindrical rotating body and the value of the slit opening area ratio are not changed as compared to Example 1, and therefore the same evaluation results are obtained.

Further, as shown in Table 2, excellent treatment results were obtained as in the case of Example 1 also in Examples 14 to 16 in which the type of the photosensitive resin original printing plate (photosensitive resin layer) was changed.

On the other hand, in Comparative Example 1, the slit opening area ratio is much higher than its preferred range, and therefore the maximum throughput is low.

In Comparative Example 2, the slit opening area ratio is lower than its preferred range, and therefore the resin removal ratio is low.

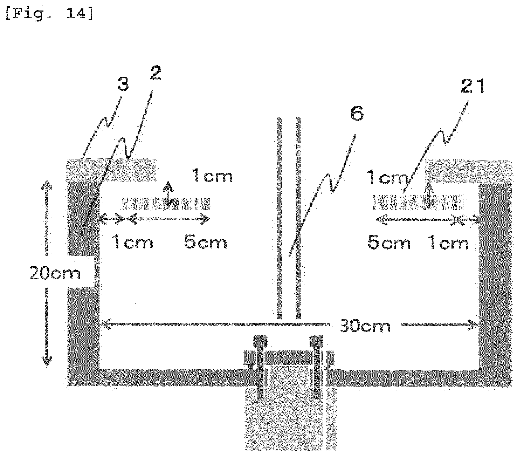

In Comparative Example 3, as shown in FIG. 14, an inside disk 21 was provided inside the cylindrical rotating body when centrifugal separation was performed. The inside disk was formed from a polypropylene plate having a thickness of 0.3 mm and was fixed to a top lid with four bolts at a position inside the cylindrical rotating body shown in FIG. 14. In the case of this system, a convection flow is generated in the rotating cylinder, and therefore the resin flocculate removal ratio is low, and separation efficiency is poor.

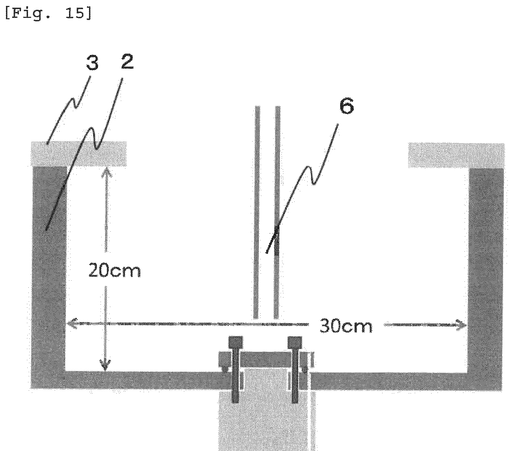

In Comparative Example 4, as shown in FIG. 15, no spacer was inserted, and therefore centrifugal separation was performed without providing any slit. In this case, the treated developer was taken out by overflow as shown in FIG. 5, and therefore the suspended resin flocculate accumulated inside the cylindrical rotating body by centrifugal force flows out together with the treated developer so that the resin flocculate can hardly be separated.

Industrial Applicability

According to the present invention, it is possible to efficiently separate and remove the resin flocculate from the used developer by a simple structure without using any inside disk. Therefore, the present invention is very useful in the industrial field.

## Claims

1. A device for recycling a used water-based developer after development of a flexographic original printing plate having a photosensitive resin layer containing a water-dispersible synthetic rubber-based polymer, **characterized in that** the device comprises a centrifugal separator (18) having a rotating body (2) for separating a resin flocculate (10) from the used water-based developer, wherein a cross-sectional shape of the rotating body (2) in a vertical direction including a rotation shaft (5) of the rotating body (2) substantially has a cylindrical or truncated-conical outline, and wherein the rotating body (2) has a slit (4) provided in a side surface thereof so as to allow the used water-based developer after the centrifugation to flow out from an inside to an outside of the rotating body (2), wherein, when a total area of an opening of the slit (4) open to the inside of the rotating body (2) is defined as A cm$^2$, and an internal volume of the rotating body (2) is defined as B cm$^3$, a value of a slit opening area ratio (B/A) is in a range of 30000 to 140000.

2. The device for recycling according to claim 1, wherein the rotating body (2) is constituted from an upper part and a lower part which are separated from each other, and wherein the slit (4) is formed between the upper part and the lower part.

3. The device for recycling according to claim 1 or 2, wherein the opening of the slit (4) is provided at a position equal to or higher than a middle of a height of an inner wall of the rotating body (2).

4. The device for recycling according to any of claims 1 to 3, wherein a non-woven fabric (8) or a bag made of a resin sheet for collecting the resin flocculate (10) is provided in such a manner that the non-woven fabric (8) or the bag covers the inner wall of the rotating body (2).

5. The device for recycling according to any of claims 1 to 4, wherein the water-dispersible synthetic rubber-based polymer has a butadiene skeleton and/or a styrene skeleton.

6. A method for recycling a used water-based developer after development of a flexographic original printing plate having a photosensitive resin layer containing a water-dispersible synthetic rubber-based polymer, **characterized in that** the method comprises separating a resin flocculate (10) from the used water-based developer by using the recycling device according to any of claims 1 to 5.

7. An apparatus for developing a flexographic original printing plate having a photosensitive resin layer containing a water-dispersible synthetic rubber-based polymer, by using a water-based developer containing a recycled water-based developer, **characterized in that** the apparatus comprises the recycling device according to any of claims 1 to 5 so as to recycle a used water-based developer after development.

## Patentansprüche

1. Vorrichtung zum Recyceln eines gebrauchten wasserbasierten Entwicklers nach dem Entwickeln einer flexografi-

# EP 4 009 105 B1

schen Originaldruckplatte mit einer photosensitiven Harzschicht, welche ein wasserdispergierbares synthetisches Gummipolymer enthält,
**dadurch gekennzeichnet,**

**dass** die Vorrichtung einen Zentrifugalseparator (18) mit einem rotierenden Körper (2) zum Abtrennen eines Harzflockulats (10) von dem gebrauchten wasserbasierten Entwickler umfasst,
wobei die Querschnittsform des rotierenden Körpers (2) in einer vertikalen Richtung, die einen Rotationsschaft (5) des rotierenden Körpers (2) einschließt, im Wesentlichen eine zylindrische oder kegelstumpfförmige Kontur aufweist, und
wobei der rotierende Körper (2) einen Schlitz (4) aufweist, der in einer Seitenfläche ausgebildet ist, sodass der gebrauchte wasserbasierte Entwickler nach dem Zentrifugieren aus dem Inneren nach außen aus dem rotierenden Körper (2) ausströmen kann,
wobei, wenn eine Gesamtfläche einer Öffnung des Schlitzes (4), die nach innen zum Inneren des rotierenden Körpers (2) geöffnet ist, als A cm$^2$ definiert ist und ein Innenvolumen des rotierenden Körpers (2) als B cm$^3$ definiert ist, ein Wert eines Schlitzöffnungsflächenverhältnisses (B/A) im Bereich von 30000 bis 140000 liegt.

2. Vorrichtung zum Recyceln nach Anspruch 1,
wobei der rotierende Körper (2) aus einem oberen Teil und einem unteren Teil besteht, die voneinander getrennt sind, und wobei der Schlitz (4) zwischen dem oberen Teil und dem unteren Teil ausgebildet ist.

3. Vorrichtung zum Recyceln nach Anspruch 1 oder 2,
wobei die Öffnung des Schlitzes (4) an einer Position vorgesehen ist, die auf gleicher Höhe oder höher liegt als die Mitte der Höhe der Innenwand des rotierenden Körpers (2).

4. Vorrichtung zum Recyceln nach einem der Ansprüche 1 bis 3,
wobei ein Vliesstoff (8) oder ein Beutel aus einer Harzfolie zum Sammeln des Harzflockulats (10) derart vorgesehen ist, dass der Vliesstoff (8) oder der Beutel die Innenwand des Rotierenden Körpers (2) bedeckt.

5. Vorrichtung zum Recyceln nach einem der Ansprüche 1 bis 4,
wobei das wasserdispergierbare synthetische Gummipolymer ein Butadien-Skelett und/oder ein Styrol-Skelett aufweist.

6. Verfahren zum Recyceln eines gebrauchten wasserbasierten Entwicklers nach dem Entwickeln einer flexografischen Originaldruckplatte mit einer photosensitiven Harzschicht, welche ein wasserdispergierbares synthetisches Gummipolymer enthält,
**dadurch gekennzeichnet,**
**dass** das Verfahren umfasst, ein Harzflockulat (10) von dem gebrauchten wasserbasierten Entwickler unter Verwendung der Vorrichtung zum Recyceln nach einem der Ansprüche 1 bis 5 abzutrennen.

7. Gerät zum Entwickeln einer flexografischen Originaldruckplatte mit einer photosensitiven Harzschicht, welche ein wasserdispergierbares synthetisches Gummipolymer enthält, unter Verwendung eines wasserbasierten Entwicklers, der einen recycelten wasserbasierten Entwickler enthält,
**dadurch gekennzeichnet,**
**dass** das Gerät die Vorrichtung zum Recyceln nach einem der Ansprüche 1 bis 5 umfasst, um einen gebrauchten wasserbasierten Entwickler nach dem Entwickeln zu recyceln.

## Revendications

1. Dispositif pour le recyclage d'un révélateur à base d'eau usée après développement d'une plaque d'impression flexographique d'origine ayant une couche de résine photosensible contenant un polymère à base de caoutchouc synthétique dispersible dans l'eau, **caractérisé en ce que** le dispositif comprend un séparateur centrifuge (18) ayant un corps rotatif (2) pour séparer un floculat de résine (10) du révélateur à base d'eau usée, dans lequel une forme en coupe transversale du corps rotatif (2) dans une direction verticale incluant un arbre de rotation (5) du corps rotatif (2) a essentiellement un contour cylindrique ou tronconique, et dans lequel le corps rotatif (2) a une fente (4) prévue dans une surface latérale de celui-ci de manière à permettre au révélateur à base d'eau usée après la centrifugation de s'écouler d'un intérieur vers un extérieur du corps rotatif (2), dans lequel, lorsqu'une surface totale d'une ouverture de la fente (4) ouverte vers l'intérieur du corps rotatif (2) est définie comme A cm$^2$ et un volume interne du corps rotatif (2)

17

est défini comme B cm$^3$, une valeur d'un rapport de surface d'ouverture de fente (B/A) est dans une plage de 30 000 à 140 000.

2. Dispositif pour le recyclage selon la revendication 1, dans lequel le corps rotatif (2) est constitué d'une partie supérieure et d'une partie inférieure qui sont séparées l'une de l'autre, et dans lequel la fente (4) est formée entre la partie supérieure et la partie inférieure.

3. Dispositif pour le recyclage selon la revendication 1 ou 2, dans lequel l'ouverture de la fente (4) est prévue à une position supérieure ou égale à un milieu d'une hauteur d'une paroi interne du corps rotatif (2).

4. Dispositif pour le recyclage selon l'une quelconque des revendications 1 à 3, dans lequel un tissu non tissé (8) ou un sac réalisé en une feuille de résine pour recueillir le floculat de résine (10) est prévu de telle sorte que le tissu non tissé (8) ou le sac couvre la paroi interne du corps rotatif (2).

5. Dispositif pour le recyclage selon l'une quelconque des revendications 1 à 4, dans lequel le polymère à base de caoutchouc synthétique dispersible dans l'eau a un squelette de butadiène et/ou un squelette de styrène.

6. Procédé pour le recyclage d'un révélateur à base d'eau usée après développement d'une plaque d'impression flexographique d'origine ayant une couche de résine photosensible contenant un polymère à base de caoutchouc synthétique dispersible dans l'eau, **caractérisé en ce que** le procédé comprend séparer un floculat de résine (10) du révélateur à base d'eau usée en utilisant le dispositif de recyclage selon l'une quelconque des revendications 1 à 5.

7. Appareil pour développer une plaque d'impression flexographique d'origine ayant une couche de résine photosensible contenant un polymère à base de caoutchouc synthétique dispersible dans l'eau en utilisant un révélateur à base d'eau contenant un révélateur à base d'eau recyclée, **caractérisé en ce que** l'appareil comprend le dispositif de recyclage selon l'une quelconque des revendications 1 à 5 de manière à recycler un révélateur à base d'eau usée après développement.

[Fig. 1]

[Fig. 2]

[Fig. 3]

[Fig. 4]

[Fig. 5]

[Fig. 6]

[Fig. 7]

EP 4 009 105 B1

[Fig. 8]

[Fig. 9]

23

[Fig. 10]

[Fig. 11]

[Fig. 12]

(a)

(b)

[Fig. 13]

(a)

(b)

[Fig. 14]

[Fig. 15]

**EP 4 009 105 B1**

**REFERENCES CITED IN THE DESCRIPTION**

**Patent documents cited in the description**

- JP 6194824 A
- JP 10034147 A
- JP 7328620 A
- JP 11047638 A
- US 5505863 A
- WO 2018180252 A1